# EUROPEAN PATENT APPLICATION

(11) **EP 4 675 300 A1**
(43) Date of publication of application: **07.01.2026**
(21) Application number: 24185726.7
(22) Date of filing: 01.07.2024
(51) Int. Cl.: G01R 33/24, G01R 33/02, G01R 33/28, G01R 33/022, G01R 33/10

(54) **METHOD AND HANDHELD MOBILE DEVICE FOR DETERMINING A SAFETY HAZARD DUE TO MAGNETIC FIELDS**

(71) Applicant: Koninklijke Philips N.V., 5656 AG Eindhoven (NL)
(72) Inventor: WEIß, Steffen, Eindhoven (NL); VOGTMEIER, Gereon, Eindhoven (NL)
(74) Representative: Philips Intellectual Property & Standards

(57) **Abstract**

The invention concerns a handheld mobile device for determining a safety hazard due to magnetic fields, in particular a mobile phone, comprising a sensor unit comprising at least one magnetic field sensor and a position sensor; wherein the magnetic field sensor is configured to measure a magnetic field vector of an environment of the handheld mobile device; wherein the position sensor is configured to measure a position information of the handheld mobile device; a processing unit configured to calculate magnetic field data based on the measured magnetic field vector and the position information, wherein the magnetic field data comprises at least one of a strength of a magnetic field, magnet field gradient, a magnetic force, and electromagnetic induction, and determine whether the handheld mobile device is in a range of a magnetic fringe field of a Magnetic Resonance system based on the calculated magnetic field data. The invention further concerns a method for determining a safety hazard due to magnetic fields for a handheld mobile device, in particula2r a mobile phone.

## Description

### FIELD OF THE INVENTION

The invention relates to the field of magnetic fields, in particular to the field of determining magnetic fringe fields.

More specifically, the invention relates to the field of determining a safety hazard due to magnetic fields using a handheld mobile device.

### BACKGROUND OF THE INVENTION

The approaching of magnetic resonance systems with ferromagnetic or electric devices is a safety hazard. High standards are set, and appropriate measures are taken to prevent magnetic resonance accidents. For example, in hospitals a general room design is used, with different zones for reception, prescreening, control room, final screening, and MRI machine room. Access zones are established with warning signs, metal detectors and manual screening using test magnets in between the zones for preventing access with electronic devices and ferro-magnetic materials. Clinial magnetic resonance scanners have a typical main field B0 of 0.5T to 3T. A magnetic fringe field of such systems extends several meters from the system until the magnetic field has dropped to the strength of the earth magnetic field of about 50µT. This magnetic field (fringe field) of clinical system is a safety hazard. The magnetic field causes a magnetic force which may affect electronical devices or magnetic devices. For example, keys may be pulled of pockets or even lifting chairs can cause damage to the magnetic resonance system or patients. Medical and service staff and also patients and relatives may forget to remove electronic devices, and/or ferro-magnetic or magnetically sensitive devices before entering a room where a magnetic resonance system is installed.

### SUMMARY OF THE INVENTION

Therefore, there exist a need for optimizing safety measures for preventing a safety hazard due to magnetic fields.

An object of the invention is to provide a more effective and cheaper device and method for determining a magnetic field and possible safety hazards, which would increase the protection for both the magnetic resonance system, medical staff and patients.

The object of the present invention is solved with the subject matter of the independent claims, wherein further embodiments are incorporated in the dependent claims.

According to a first aspect of the invention a handheld mobile device for determining a safety hazard due to magnetic fields, in particular a mobile phone, is provided. The handheld mobile device comprises a sensor unit comprising at least one magnetic field sensor and a position sensor. The magnetic field sensor is configured to measure a magnetic field vector of an environment of the handheld mobile device. The position sensor is configured to measure a position information of the handheld mobile device. The handheld mobile device further comprises a processing unit configured to calculate magnetic field data based on the measured magnetic field vector and the position information, wherein the magnetic field data comprises at least one of a strength of a magnetic field, magnet field gradient, a magnetic force, and electromagnetic induction, and to determine whether the handheld mobile device is in a range of a magnetic fringe field of a Magnetic Resonance system based on the calculated magnetic field data.

In the context of the present invention, the term "handheld mobile device" shall be understood to describe any electronic portable device, which may be carried by a user. For example, a handheld mobile device may a telephone, smartphone, or tablet.

In the context of the present invention, the term "position information" shall be understood to describe any information allowing to determine a position of the device. A position information may be the location, area where the device currently is situated. Further, a position information may be a height over ground. The position information may also be a GPS data determined by the handheld mobile device. Furthermore, the position information may be a speed, information, for example along a path, of the handheld mobile device.

In the context of the present invention, the term "magnetic field data" shall be understood to describe any parameter which may specify properties of a magnetic field. For example, magnetic field data may be a vector of a magnetic field, a vector component of a magnetic field, a strength of a magnetic field, a gradient of a magnetic field, magnetic flux density, and other parameters. The magnetic force is the product of the magnetic moment of the device and the gradient of the magnetic field. The magnetic moment depends on magnetic material properties of the device and the magnetic field strength. As a result, the magnetic force is the product of magnetic material properties of the device, the magnetic strength of the magnetic field, and the gradient of the magnetic field. The gradient of the magnetic field is the magnitude of the spatial derivative of the magnetic field.

In the context of the present invention, the term "magnetic fringe field" shall be understood to describe a peripheral magnetic field outside of a magnetic core, for example of a magnetic resonance system. The magnetic fringe field may depend on the design of the magnet. The magnetic fringe field may extend several meters around, above, and below a magnetic resonance system. The magnetic fringe field can cause interference with nearby electronic devices. Even though the strength of the magnetic field decreases with distance from the magnetic core, the effect of the fringe of the magnetic field can still have an influence on electronic devices nearby. The magnetic fringe field of a magnetic resonance system may have a typical characteristic. It may be a large magnetic dipole having a characteristic drop of strength of magnetic field and has typical spatial pattern which differs from other magnetic fields as from high power electrical cabling, for example.

In other words, the handheld mobile device (hereinafter named also as "device") can be used as a safety guard, either as part of an (radiology and/or patient preparation) app (for staff and patients) or built into the operating system of the device. The device is able to measure a vector and/or a plurality of vectors of a magnetic field and is able to calculate a strength of the magnetic field and a magnetic field gradient. The device may be able to sense the magnetic field, in particular, the magnetic fringe field, but may not be limited to the fringe field, as any magnetic field may be detectable. For measuring the magnetic field vector, the sensor unit may use the standard magnetic sensor of the handheld mobile device, for example standard sensors included in a mobile phone, smart phone. The dynamic range (0.1µT to 5mT) and the resolution (0.1µT) of typical phone magnetic sensors as the 3-axis magnetometer may be used as a magnetic sensor. The sensor may be able to record the magnetic field with sufficient temporal resolution and SNR (signal to noise ratio). With the determination whether or not the handheld mobile device is in the range of the magnetic fringe field of the magnetic resonance system (MR), the device is able to determine a hazard due to the magnetic fringe field of the MR system. Hence, if the device in the range of the magnetic fringe filed, a safety hazard to the device or other devices carried by the user may occur.

It should be noted that any feature, function and/or element described in the following with reference to the handheld mobile device equally applies to the method, and vice versa. Accordingly, any feature, function, step and/or element described in the following with reference to one aspect of the present disclosure equally applies to any other aspect of the present disclosure.

According to an exemplary embodiment of the invention, the handheld mobile device may be configured to continuously measure the position information and the magnetic field vector over time, wherein the magnetic field vector may be measured with a higher temporal resolution than the position information. The handheld mobile device may be configured to, if the strength of the magnetic field is larger than a predetermined threshold, to increase the temporal resolution of the position information. A reasonable threshold may be 100µT because the strength of the earth's magnetic field varies from 30µT in the equatorial regions to about 60µT in the polar regions.

The continuously measurement of the position information and the magnetic field vector may be carried out continuously over time with a temporal resolution of for example one measurement per second. The resolution may not be limited to this specific temporal resolution, other lower or higher resolutions may also be possible. The magnetic field vector may be measured with a resolution of two measurements per seconds, which is higher than the measurement resolution of the position information. If the device determines that it is in a range of a magnetic (fringe) field, the temporal resolution of the position measurement is increased, such that it is equal to the resolution of the measurement of the magnetic field or even larger. It may also be possible to increase the temporal resolution of the magnetic vector simultaneously with increasing the temporal resolution of the position information. Not permanently measuring these quantities with highest possible temporal resolution may serve as an energy saving function. The determination whether a magnetic fringe field is present requires a higher temporal resolution, and this may only be started, when the threshold is exceeded.

According to an exemplary embodiment of the invention the processing unit may be configured to map the magnetic field vector as a function of a position using the measured position information representing a path in the magnetic field.

In particular, the vector may be mapped over time as a function of the position information, wherein the position information is used to determine the position or includes the position. When mapping the magnetic vector as function of the position, the magnetic field parameters, hence also the strength, gradient and force, may be assigned to a respective position of the handheld mobile device. As a result from the mapping, for each position respective magnetic field data can be determined and a distribution or course of the magnetic field (data) along a path may be determined.

According to an exemplary embodiment of the invention the processing unit may be configured to determine a presence of the magnetic fringe field, in particular of a Magnetic Resonance system, by comparing the vector field values along the path in the magnetic field with characteristic amplitude and direction of magnetic resonance system magnetic fringe fields.

The magnetic fringe field of magnetic resonance systems may comprise a characteristic amplitude, magnetic field vector direction, and range distribution, which could be determined by the handheld mobile device with the measured magnetic field vector and the therefrom calculated magnetic field data. The characteristics of the magnetic resonance system may be provided to the device from an external unit. On the other hand, the characteristics of the magnetic resonance system may be stored in a storage of the handheld mobile device. In other words, the mobile phone checks whether the path data fit to the common amplitude and direction of the magnetic field of an MR scanner.

For example, a mobile phone as the handheld mobile device, may check whether the path data fit to a common amplitude and direction of the magnetic field of an MR scanner. The search space for this task may be limited to reduce the calculation effort by exploiting common boundary conditions as: almost all MR systems have a horizontal bore with a central axis about 1m above the floor. Mobile phones are commonly carried in pockets at that height above the floor. If the mobile phone is in a call a proximity sensor of the mobile phone and a proximity sensor of connected headphones may be used to decide whether the mobile phone is held to the head for the call. Based on this info the height of the phone above the floor can be estimated as rather 1.7m.

According to an exemplary embodiment of the invention, if the position sensors may determine that the position information is not changed, the processing unit may be configured to determine whether the magnetic field vector is time dependent. Additionally, if determined that the magnetic field vector is time dependent, the processing unit may be configured to exclude a presence of a magnetic field.

The handheld mobile device may exclude that the measured magnetic vector (changing over time) belongs to a magnetic fringe field of a magnetic resonance system, because magnetic fringe fields of MR systems do generally not change over time.

According to an exemplary embodiment of the invention, the sensor unit may be configured to use any sensor in the handheld mobile device applicable for determining the position information of the handheld mobile device, wherein the magnet field sensor may be excluded from measuring the position information of the handheld mobile device. The handheld mobile device, in particular the mobile phone may use any suitable physically sensors able to determine a position except the magnet field sensor. The magnet field sensor of a mobile phone may just be configured to determine magnetic fields. Therefore, this sensor should be excluded from the position measurement.

For example, the air pressure sensor may be used to determine the position of the device. On the other hand, also an acceleration or a rotation sensor may be used for determining the position of the device.

According to an exemplary embodiment of the invention, the handheld mobile device may further comprise a control unit configured to control the handheld mobile device based on the calculated magnetic field data, and/or to provide an information about a determined hazard to the user based on the calculated magnetic field data.

The control unit may be controlled by the processing unit. Depending on the determination, whether the device is in a range of a magnetic fringe field or not, the control unit may serve as an indicator for the magnetic fringe field, or as a warning unit, or may be configured to control system parts of the device, such as sensors, processors or the like for activating and/or deactivating sensors, or processes in the device.

According to an exemplary embodiment of the invention, the processing unit may be configured to determine, whether the calculated magnetic force exceeds a predetermined threshold, wherein the predetermined threshold may be exceeded if the calculated magnetic force is larger than a gravitation force, and/or wherein the processing unit may be configured to determine, whether the calculated electromagnetic induction exceeds a predetermined threshold, which would cause an electrical interference with function of or even a hazard to the handheld mobile device.

For instance, if the magnetic force may exceed the threshold, the handheld mobile device might be pulled towards the magnetic resonance system. The same applies, when the electromagnetic induction is too high, then a damage for the handheld mobile device may occur. Therefore, in combination with the control unit the device may therefore be controlled depending on whether one of the above thresholds has been exceeded or not.

According to an exemplary embodiment of the invention, the control unit may be further configured to generate a warning based on the calculated magnetic force and/or electromagnetic induction, if the calculated magnetic force may exceeds the predetermined threshold the control unit may generate a warning for a hazard for a pulling force, if the calculated electromagnetic induction may exceeds the predetermined threshold, the control unit may generate a warning for an electrical hazard.

According to an exemplary embodiment of the invention, the control unit may be configured to control a status of the handheld mobile device, such that depending on the calculated magnetic force and electromagnetic induction, the status may be changed to at least one of electronic-off-status, warning-function-on-status, and reminder-status.

For example, the medical staff may ignore to switch off the device, the mobile phone, when just quickly entering a control room nearby a magnetic fringe field of a magnetic resonance system. Here the device, in particular the control unit, may provide dedicated warnings when coming closer to high magnetic field strength but would still accept a short time at a low magnetic field strength, but may additionally start early warning and fast sending high field warning. The control unit may be configured to turn off the device itself. On the other hand, the handheld mobile device, for instance the control unit, may be configured to indicate when the magnetic field decreases. For example, it may be indicated by the handheld mobile device, such as the control unit, when the magnetic field is below the threshold again, because the user has moved away from the magnetic resonance system.

According to an exemplary embodiment of the invention, the handheld mobile device may further comprise a storage configured to store user specific information, such as pacemaker data, or implant data, wherein the user specific information may specify a personal threshold for the user, wherein the control unit may control the handheld mobile device based on the user specific information. For example, the storage comprises a threshold for a patient with a pacemaker, wherein this threshold is lower than a threshold for a person without a pacemaker. Due to this different threshold the control unit may react faster than for other thresholds. Further, the storage may also be used for storing other data, which may be used for controlling the device or for measuring by the processing unit. The processing unit may be able to receive the stored information/data and may be configured to process the stored information/data.

According to an exemplary embodiment of the invention, the device may further comprise a guiding unit, configured to provide to the user a behavior guidance depending on the calculated magnetic force and electromagnetic induction. The guiding unit may be in connection with the storage, wherein the behavior guidance may be stored. The control unit may be configured to control the guiding unit, then depending on the measured and/or determined magnetic field data the guiding unit may provide respective behavior guidance. In other words, the guiding unit may give guidance what to do when a high magnetic force is determined and may also provide support depending on the role of the person, such as staff, patient or visitor.

According to an exemplary embodiment of the invention, the processing unit is further configured to calculate the magnetic gradient from a spatial derivation of the mapped magnetic field vector as a function of the position; and/or calculate the magnetic force based on the strength of the magnetic field, the magnetic gradient and magnetic properties of the handheld device; and/or calculate the electromagnetic induction based on the gradient of the magnetic field and the velocity.

The device may be able to calculate the magnetic field data based on the measured magnetic field vector and/or on the position information.

According to a second aspect of the invention a method for determining a safety hazard due to magnetic fields for a handheld mobile device, in particular a mobile phone, is provided. The method comprising the steps of measuring a magnetic field vector of an environment of the handheld mobile device using magnetic field sensor, measuring a position information of the handheld mobile device using a position sensor, calculating magnetic field data based on the measured magnetic field vector and the position information, wherein the magnetic field data comprises at least one of a strength of a magnetic field, a magnetic force, magnet field gradient, and electromagnetic induction, determining whether the handheld mobile device is in a range of a magnetic fringe field of a Magnetic Resonance system based on the calculated magnetic field data.

The order of the various steps as described herein is provided for the sake of illustration and may be altered without departing from the scope of the present teachings.

In accordance with various embodiments of the present disclosure, the method described herein may be implemented using a hardware computer system that executes software programs. Further, in an exemplary, non-limited embodiment, implementations can include distributed processing, component/object distributed processing, and parallel processing. Virtual computer system processing may implement one or more of the methods or functionalities as described herein, and a processor described herein may be used to support a virtual processing environment.

According to a third aspect of the invention, a computer program element comprising instructions, when the program is executed by a computer, cause the computer to carry out the method as described herein with exemplary embodiments. In detail, the program may cause the computer to carry out the method for determining a safety hazard due to magnetic fields for a handheld mobile device as described with any one of the embodiments herein.

For example, the method and/or the computer program element may be implemented as an App, for instance as part of radiology App or Patient App used in a hospital.

For example, the method and/or the computer program element may be implemented as part of the operating system of the device. In that case, the vendor of the device provides the above functions to warn and protect the device from hazardous magnetic fringe fields as part of the device as delivered to all customers. These functions may be permanently active to protect the phone. Alternatively, the vendor may provide a switch in the system settings of the device where the user may have the option to switch off or customize the function, e.g. by entering data of an implant.

According to a fourth aspect of the invention, A computer-readable medium comprising instructions which, when executed by a computer, cause the computer to carry out the method of any one of the embodiments as described herein. In detail, the computer-readable medium may cause the computer to carry out the method for determining a safety hazard due to magnetic fields for a handheld mobile device as described with any one of the embodiments herein.

It has to be noted that embodiments of the invention have been described with reference to different subject matters. In particular, some embodiments have been described with reference to device type claims whereas other embodiments have been described with reference to method type claims. However, a person skilled in the art will gather from the above and the following description that, unless other notified, in addition to any combination of features belonging to one type of subject matter also any combination between features relating to different subject matters, in particular between features of the device type claims and features of the method type claims is considered as to be disclosed with this application.

It should be noted that the term "comprising" does not exclude other elements or steps and "a" or "an" does not exclude a plurality. Also, elements described in association with different embodiments may be combined. It should also be noted that reference signs in the claims should not be construed as limiting the scope of the claims.

### BRIEF DESCRIPTION OF THE DRAWINGS

The aspects defined above, and further aspects of the present invention are apparent from the examples of embodiment to be described hereinafter and are explained with reference to the examples of embodiment. The invention will be described in more detail hereinafter with reference to examples of embodiment but to which the invention is not limited.
Fig 1 illustrates schematically a magnetic field amplitude and extending direction around a magnetic resonance system and a handheld mobile device according to an exemplary embodiment of the invention.
Fig. 2 illustrates a schematically room plan indicating a path of a handheld mobile device along magnetic fringe fields according to an exemplary embodiment of the invention.
Fig. 3 illustrates a diagram showing different magnetic field vector components measured by a device according to an exemplary embodiment of the invention.

### DETAILED DESCRIPTION OF EMBODIMENTS

The illustrations in the drawings are schematic. It is noted that in different figures similar or identical elements are provided with the same reference signs.

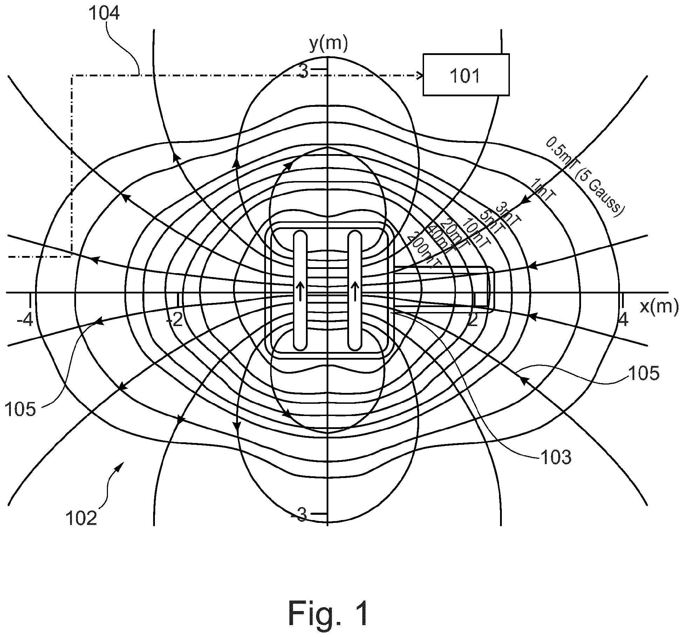

Fig. 1 illustrates schematically a magnetic field amplitude and extending direction around a magnetic resonance system 103 and a handheld mobile device 101.

The magnetic resonance system 103, in Fig. 1 is a 1.5T magnetic resonance scanner. For comparison the earth's field is at 0.05T. As can be seen in Fig. 1 the amplitude and also the direction of the magnetic field vector 105 changes in a characteristic way around the system 103. The principal shape at larger distance is that of a magnetic dipole as depicted in Fig. 1, but there may exist local deviations due to active shielding. When the handheld mobile device 101 traverses a path 104 through this magnetic field the different magnetic field vectors 105 can be measured along different positions of the path 104. In Fig. 1 it is shown that depending on the distance, illustrated in meters on the X-axis, the strength of the magnetic field, illustrated with 200mT to 0,5 mT, decreases the longer the distance to the MR system 103. As the device measures the different magnetic field vectors, the strength of the magnetic field can be calculated. Depending on the on the calculated magnetic field data, such as the strength of the magnetic field, hazardous magnetic forces or electromagnetic induction can be determined.

The position information along the path 104 and the magnetic field vector 105 is measured continuously over the time, such that a path through the magnetic fringe field can be determined, for example by mapping the magnetic field vector 105 as a function of the position.

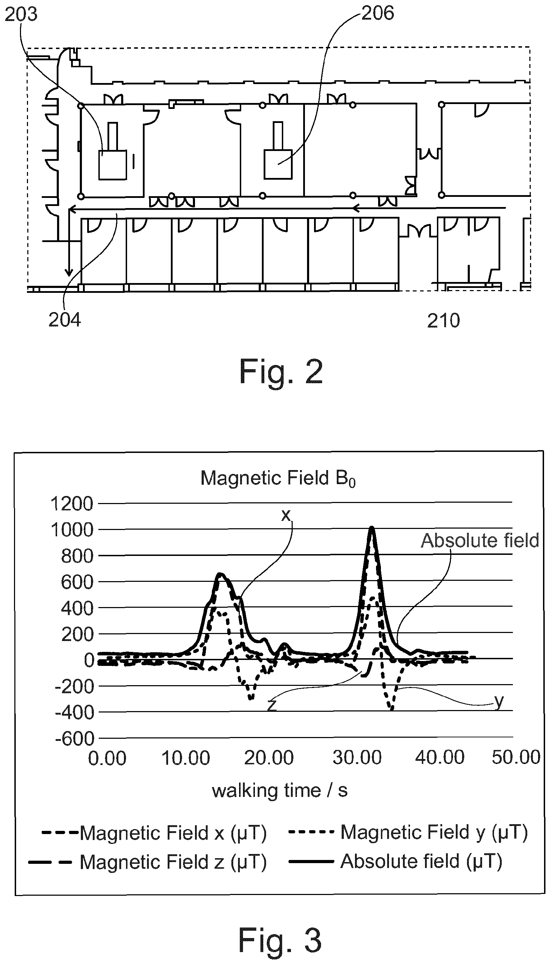

Fig. 2 illustrates a schematically room plan 210 indicating a path 204 of a handheld mobile device (not illustrated) along magnetic fringe fields according to an exemplary embodiment of the invention. In Fig. 2 two magnetic resonance systems 203 and 206 are illustrated. The path 204 pf the device passes along these two magnetic resonance systems 203, 203. Therefore, the device would be able to measure both fringe fields.

Fig. 3 illustrates a diagram showing different magnetic field vector components measured by a device according to an exemplary embodiment of the invention. The different vector components are measured in µT and are illustrated over a walking time in seconds s. The magnetic field vector for the x-component is illustrated as a dashed line x, the z-component is illustrated as a semicolon line z and the y-component is illustrated as a dotted line y, wherein the absolute field strength is illustrated as a continuous line. The absolute field strength may be derived from all three magnetic field vector components. This diagram shows an example how measured magnetic field vectors mapped as a function of the position. The path is illustrated as the walking time. The diagram of Fig. 3 illustrates the measured vector components and the absolute magnetic field strength when walking along the path as illustrated in Fig. 2. The baseline magnitude as several meters distances from the magnetic resonance systems 203 and 206 is 50 µT. The magnetic field reaches a peak when the magnetic resonance systems 203, 206 are passed by the handheld mobile device.

### LIST OF REFERENCE SIGNS:

- 101: device
- 102: magnetic field
- 103: magnetic resonance system
- 104, 204: path of the device
- 105: magnetic field vector
- 203, 206: magnetic resonance system
- 210: room plan
- x: Magnetic Field x
- y: Magnetic Field y
- z: Magnetic Field z

## Claims

1. A handheld mobile device for determining a safety hazard due to magnetic fields, in particular a mobile phone, comprising
a sensor unit comprising at least one magnetic field sensor and a position sensor;
wherein the magnetic field sensor is configured to measure a magnetic field vector of an environment of the handheld mobile device;
wherein the position sensor is configured to measure a position information of the handheld mobile device;
a processing unit configured to
calculate magnetic field data based on the measured magnetic field vector and the position information, wherein the magnetic field data comprises at least one of a strength of a magnetic field, magnet field gradient, a magnetic force, and electromagnetic induction,
determine whether the handheld mobile device is in a range of a magnetic fringe field of a Magnetic Resonance system based on the calculated magnetic field data.

2. The handheld mobile device according to claim 1,
wherein the handheld mobile device is configured to continuously measure the position information and the magnetic field vector over time,
wherein the magnetic field vector is measured with a higher temporal resolution than the position information,
if the strength of the magnetic field is larger than a predetermined threshold, the temporal resolution of the position information is increased.

3. The handheld mobile device according to claim 1 or 2,
wherein the processing unit is configured to map the magnetic field vector as a function of a position using the measured position information representing a path in the magnetic field.

4. The handheld mobile device according to any of the preceding claims,
wherein the processing unit is configured to determine a presence of the magnetic fringe field, in particular of a Magnetic Resonance system, by comparing the vector field values along the path in the magnetic field with characteristic amplitude and direction of Magnetic Resonance system magnetic fringe fields.

5. The handheld mobile device according to any of the preceding claims,
wherein if the position sensors determines that the position information is not changed, the processing unit is configured to determine whether the magnetic field vector is time dependent,
if determined that the magnetic field vector is time dependent, a presence of a magnetic field is excluded.

6. The handheld mobile device according to any of the preceding claims,
wherein the sensor unit is configured to use any sensor in the handheld mobile device applicable for determining the position information of the handheld mobile device, wherein the magnet field sensor is excluded from measuring the position information of the handheld mobile device.

7. The handheld mobile device according to any of the preceding claims, wherein the handheld mobile device further comprises
a control unit configured to
control the handheld mobile device based on the calculated magnetic field data,
provide an information about a determined hazard to the user based on the calculated magnetic field data.

8. The handheld mobile device according to any of the preceding claims,
wherein the processing unit is configured to determine, whether the calculated magnetic force exceeds a predetermined threshold, wherein the predetermined threshold is exceeded if the calculated magnetic force is large than a gravitation force, and/or
wherein the processing unit is configured to determine, whether the calculated electromagnetic induction exceeds a predetermined threshold, which would cause an electrical interference with function of or even a hazard to the handheld mobile device.

9. The handheld mobile device according to claim 6 to 8,
wherein the control unit is further configured to generate a warning based on the calculated magnetic force and/or electromagnetic induction,
if the calculated magnetic force exceeds the predetermined threshold the control unit generates a warning for a hazard for a pulling force,
if the calculated electromagnetic induction exceeds the predetermined threshold, the control unit generates a warning for an electrical hazard.

10. The handheld mobile device according to claim 6 to 9,
wherein the control unit is configured to control a status of the handheld mobile device, such that depending on the calculated magnetic force and electromagnetic induction, the status is changed to at least one of electronic-off-status, warning-function-on-status, and reminder-status.

11. The handheld mobile device according to any of the preceding claims, further comprising
a storage configured to store user specific information, such as peacemaker data, or implant data, wherein the user specific information specifies a personal threshold for the user,
wherein the control unit is able to control the handheld mobile device based on the user specific information.

12. The handheld mobile device according to any of the preceding claims, wherein the device further comprises
a guiding unit, configured to provide to the user a behavior guidance depending on the calculated magnetic force and electromagnetic induction.

13. The handheld mobile device according to any of the preceding claims 3 to 12,
wherein the processing unit is further configured to
calculate the magnetic gradient from a spatial derivation of the mapped magnetic field vector as a function of the position; and/or
calculate the magnetic force based on the strength of the magnetic field, the magnetic gradient and magnetic properties of the handheld device; and/or
calculate the electromagnetic induction based on the gradient of the magnetic field and the velocity.

14. Method for determining a safety hazard due to magnetic fields for a handheld mobile device, in particular a mobile phone, comprising the steps of
measuring a magnetic field vector of an environment of the handheld mobile device using magnetic field sensor,
measuring a position information of the handheld mobile device using a position sensor,
calculating magnetic field data based on the measured magnetic field vector and the position information, wherein the magnetic field data comprises at least one of a strength of a magnetic field, a magnetic force, magnet field gradient, and electromagnetic induction,
determining whether the handheld mobile device is in a range of a magnetic fringe field of a Magnetic Resonance system based on the calculated magnetic field data.

15. Computer program element comprising instructions, when the program is executed by a computer, cause the computer to carry out the method of claim 14.
